(19) Europäisches Patentamt
European Patent Office
Office européen des brevets

(11) **EP 1 057 252 B1**

(12) **EUROPEAN PATENT SPECIFICATION**

(45) Date of publication and mention
of the grant of the patent:
**12.03.2008 Bulletin 2008/11**

(51) Int Cl.:
*H03C 3/08* (2006.01)     *H03C 3/09* (2006.01)

(21) Application number: **99909493.1**

(22) Date of filing: **23.02.1999**

(86) International application number:
**PCT/US1999/003285**

(87) International publication number:
**WO 1999/043080 (26.08.1999 Gazette 1999/34)**

(54) **DIRECT DIGITAL SYNTHESIS OF PRECISE, STABLE ANGLE MODULATED RF SIGNAL**

DIRECT-DIGITAL-SYNTHETISIERER FÜR WINKELMODULATION

SYNTHESE NUMERIQUE DIRECTE DE SIGNAL RF PRECIS, STABLE ET A MODULATION ANGULAIRE

(84) Designated Contracting States:
**AT BE CH CY DE DK ES FI FR GB GR IE IT LI LU MC NL PT SE**
Designated Extension States:
**AL LT LV MK RO SI**

(30) Priority: **23.02.1998 US 27954**

(43) Date of publication of application:
**06.12.2000 Bulletin 2000/49**

(73) Proprietor: **Matsushita Electric Industrial Co., Ltd.**
**Kadoma-shi**
**Osaka 571-8501 (JP)**

(72) Inventors:
• **McCUNE, Earl, W.**
**Santa Clara, CA 95050 (US)**
• **SANDER, Wendell**
**Los Gatos, CA 95032 (US)**

(74) Representative: **Gassner, Wolfgang et al**
**Patentanwälte**
**Dr. Gassner & Partner**
**Marie-Curie-Strasse 1**
**91052 Erlangen (DE)**

(56) References cited:
**US-A- 4 282 497**     **US-A- 4 755 774**
**US-A- 5 834 985**

**Description**

The present invention relates to radio frequency modulators, particularly digital radio frequency modulators.

Modulation can be defined as the alteration of some characteristic of a known signal or waveform, i.e., a carrier, as a function of some unknown signal or waveform that conveys information. In radio-frequency (RF) communication systems, the carrier is typically a sinusoid, and there are several methods of modulating the carrier. These include linear modulation, angle modulation, and various types of pulse modulation. Given a sinusoidal carrier described by the equation $A(t)\cos(\omega_c t + \phi(t))$, there are two parameters, the amplitude and the phase angle, that can be varied in accordance with an information signal. Linear modulation results when the amplitude is varied as a linear function of the information signal. Angle modulation includes phase modulation and frequency modulation. If a term is included in the argument of the sinusoidal function that varies in proportion to the information signal, the result is phase modulation. If the argument is such that the difference in the instantaneous frequency and the carrier frequency is proportional to the information signal, the result is frequency modulation. The document US-A-4 125 817 disclose an example of a phase modulator.

Demodulation of RF signals has typically involved a quadrature detector having two branches, an I ("in-phase") branch and a Q ("quadrature" or 90° phase-shifted) branch. In the I branch, a received signal is multiplied by the cosine form of the carrier signal and then passed through a low-pass filter. In the Q branch, the received signal is multiplied by the sine form of the carrier signal and pass through a low-pass filter. Quadrature detectors of this type are linear, well-understood, and almost universally used. To obtain the information signal from the I and Q components produced by the respective I and Q branches of the quadrature detector, signal processing is performed. In particular, the phase of the signal may be obtained by taking the inverse tangent of the ratio of Q to I. The amplitude of the signal may be obtained according to the Pythagorean theorem by taking the square root of the sum of the squares of I and Q. These mathematical operations are non-linear.

Two salient observations may therefore be made concerning quadrature detection. First, detection proceeds in two steps, a first mixing step (to obtain I and Q) that is linear and a second signal processing step to which non-linearities are relegated. Second, a coordinate system conversion is first performed and then reversed. That is, the received signal, which may be readily described in polar coordinates in terms of the desired quantities of amplitude and phase, is first converted to rectangular coordinates by projecting the instantaneous signal vector in polar coordinates onto the X (I) and Y (Q) axes, and is then converted back to polar coordinates to obtain amplitude and phase. Such conversions require circuitry that occupies space and consumes power-both of which may be precious commodities, especially in mobile applications such as cellular telephones, pagers, etc. Such conversions may also entail substantial inaccuracies.

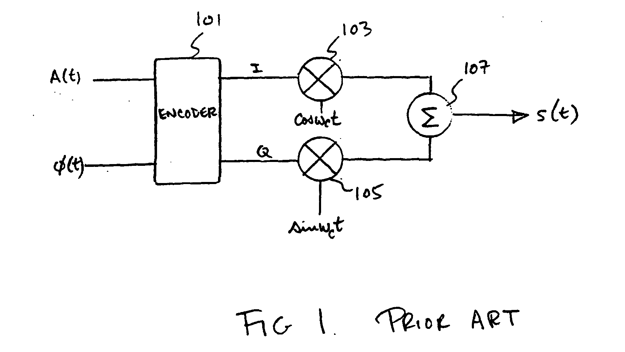

A similar situation exists on the transmit side with respect to RF modulators. That is, amplitude and phase information is originally represented in polar form. I and Q processing is then performed in which amplitude and phase information is encoded as I and Q signals which are then converted back to polar form and summed to form the final output signal. This process is illustrated in Figure 1. One widely used type of modulation, Phase Shift Keying (PSK), requires the transmit signal to undergo accurate phase shifts and to exhibit good phase stability PSK is used in GSM cellular telephones, for example. A conventional modulator of the quadrature type, while it exhibits good phase stability, achieves only marginal accuracy. Sophisticated coding schemes may be required to compensate for inaccuracies of the modulator, and performance under noisy conditions may noticeably deteriorate.

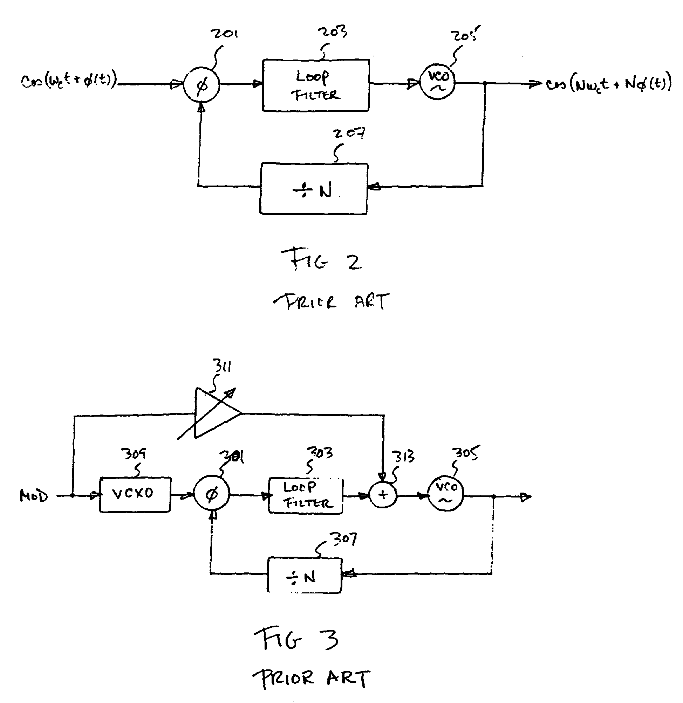

Beside conventional quadrature techniques, various other modulation techniques are known. In one such technique, a phase lock loop (PLL) is used to multiply a modulated signal in frequency and phase to obtain a high frequency signal (e.g., 900 MHz). Referring to Figure 2, a PLL includes a phase detector 201, a loop filter 203, a Voltage Controlled Oscillator (VCO) 205, and a divide by N counter 207. In the case of a 900 MHz output signal, a typical divisor might be 64, for example. If a modulated signal $\cos(\omega_c t + \phi(t))$ is applied to the input of the circuit, then ideally, a modulated signal $\cos(N\omega_c t + N\phi(t))$ is produced at the output of the circuit. The stability of the circuit, however, is poor unless the loop filter is made to have a narrow bandwidth. With a narrow bandwidth loop filter, the circuit is no longer able to track rapid changes in the modulated input signal, producing inaccuracies in the modulated output signal.

To overcome the foregoing difficulty, an arrangement shown in Figure 3 has been devised. A baseband modulation signal is applied to a Voltage Controlled Crystal Oscillator (VCXO) 309 to produce a modulated signal which is applied to the input of a PLL, as before. An additional feedforward path is used to inject the baseband modulation signal into the PLL at a point past the loop filter. More particularly, the baseband modulation signal is applied to an adjustable gain amplifier 311. The output of the adjustable gain amplifier is applied to an adder 313 situated between the loop filter and the VCO. The gain of the amplifier is adjusted so that the effects of the loop filter in removing some of the modulation is precisely offset by reinjecting the modulation signal. Unfortunately, achieving precisely the correct adjustment is a painstaking manual process. Furthermore, although sufficient precision may be obtained for FM radio communications, the precision required for PSK radio communications is lacking.

The present invention, generally speaking, provides an RF modulator that allows precise, stable phase shifts to be obtained. The modulator uses a PLL structure including an auxiliary feedforward path used to inject a baseband modulation signal into the PLL at a point past a loop filter of the PLL. A phase demodulator recovers phase information from the output signal of the PLL. The recovered phase information is compared to the phase information of the baseband modulation signal. A resulting error signal is used to control injection of the baseband modulation signal into the PLL, to automatically achieve the correct "dosage." A precise, adaptive, phase-stable modulator results. The adaptation of the modulator compensates for variability of the VCO and other components of the PLL.

Figure 1 is a block diagram of a conventional quadrature RF modulator;

Figure 2 is a block diagram of a conventional PLL-based RF modulator;

Figure 3 is a block diagram of a conventional PLL-based RF modulator having a baseband modulation signal injection feature;

Figure 4 is a block diagram of an RF modulator in accordance with the present invention;

Figure 5 is a first timing diagram illustrating operation of the frequency sampling circuit of Figure 21;

Figure 6 is a second timing diagram illustrating operation of the frequency sampling circuit of Figure 21;

Figure 7 is a graph of two alternative weighting functions that may be used to perform digital filtering of a digital bit stream produced by a circuit such as that of Figure 21;

Figure 8 is a graph illustrating the accuracy obtained from a digital frequency discriminator using a constant weighting function;

Figure 9 is a graph illustrating the accuracy obtained from a digital frequency discriminator using a triangular weighting function;

Figure 10 is a block diagram of one example of a digital filter that may be used in conjunction with a frequency sampling circuit such as that of Figure 21;

Figure 11A is a tabulation illustrating one method of digital phase discrimination;

Figure 11B is a plot showing results of the method of Figure 11A;

Figure 11C is a plot of a weighting function used in connection with Figures 11A and 11B;

Figure 12A is a tabulation illustrating another method of digital phase discrimination;

Figure 12B is a plot showing results of the method of Figure 12A;

Figure 12C is a plot of a weighting function used in connection with Figures 12A and 12B;

Figure 13 is a block diagram of digital phase discrimination hardware in accordance with the technique of Figure 12;

Figure 14A is a tabulation illustrating yet another method of digital phase discrimination;

Figure 14B is a plot showing results of the method of Figure 14A;

Figure 14C is a plot of a weighting function used in connection with Figures 14A and 14B;

Figure 15 is a block diagram of digital phase discrimination hardware in accordance with the technique of Figure 14;

Figure 16A is a tabulation illustrating still another method of digital phase discrimination;

Figure 16B is a plot showing results of the method of Figure 16A;

Figure 16C is a plot of a weighting function used in connection with Figures 16A and 16B;

Figure 17 is a block diagram of digital phase discrimination hardware in accordance with the technique of Figure 16.

Figure 18 is a block diagram illustrating a sampled-data model of a Sigma-Delta modulator and of a sampling circuit applied to frequency sampling in accordance with one embodiment of the present invention;

Figure 19 is a table helpful in explaining operation of the circuit model of Figure 18 in the instance of an input frequency that is 0.6875 times a reference frequency;

Figure 20 is a timing diagram illustrating the principle of operation of the circuit model of Figure 18 as applied to frequency sampling;

Figure 21 is a schematic diagram of one example of a frequency sampling circuit described by the circuit model of Figure 18.

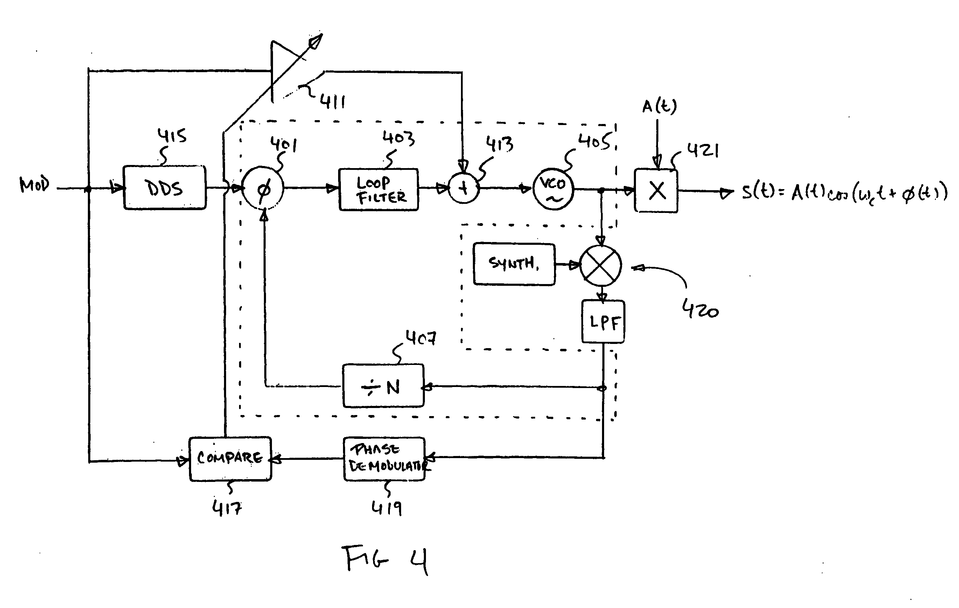

Referring now to Figure 4, a block diagram of an RF modulator in accordance with the present invention is shown. A portion of the modulator indicated within dashed lines is substantially the same as a corresponding portion of the conventional modulator of Figure 3. Optionally, the modulator of Figure 4 may include a downconverter 420 consisting of a frequency synthesizer, a mixer and a low pass filter. In instances where the output frequency of the modulator is very high, the downconverter reduces the frequency to one that may be more readily handled by the divide by N counter. Note, however, that in other instances N may be equal to one. Also, the modulator of Figure 4 may optionally include an amplitude modulation stage 421. In some modulation schemes, both the amplitude and phase characteristics of the signal may be modulated, in which instance the amplitude modulation stage is used to impart the desired amplitude modulation.

Preferably, instead of the VCXO of Figure 3, the modulator of Figure 4 uses a Direct Digital Synthesis (DDS) circuit 415 to produce a modulated input signal that is applied as a reference signal to the PLL. Such a DDS circuit may be based upon a known Number Controlled Modulated Oscillator (NCMO) described in U.S. Patent No. 4,746,880 issued May 24, 1988, entitled Number Controlled Modulated Oscillator, incorporated herein by reference. A baseband modulation signal is applied to the DDS circuit to produce the modulated input signal, which is then applied as a reference signal to the PLL.

The stability and precision of the present modulator derive from an additional feedback loop including a phase demodulator 419 and a comparison circuit 417. The phase demodulator may be of a type described in U.S. Patent Application No. 09/006,938 (Atty. Dkt. No. 32219-003), entitled DIGITAL PHASE DIESCRIMINATION BASED ON FREQUENCY SAMPLING, filed January 14, 1998, incorporated hereinafter.

The phase demodulator 419 recovers phase information from the output signal of the PLL. Using a comparison circuit 417, the recovered phase information is compared to the phase information of the baseband modulation signal. A resulting error signal is used to control injection of the baseband modulation signal into the PLL, to automatically achieve the correct "dosage." That is, an output signal of the comparison circuit 417 sets the gain of the adaptive gain amplifier 411 to the value required in order to match the phase information carried by the output signal to the desired phase information. The painstaking adjustment process characteristic of the prior art is eliminated. Furthermore, the adaptation process performed by the present modulator is continuous, operating whenever the modulator is turned on. The effects of environmental conditions, component variations, component aging, etc., can all be compensated for.

The phase demodulator of U.S. Patent Application No. 09/006,938 (Atty. Dkt. No. 32219-003), entitled DIGITAL PHASE DIESCRIMINATION BASED ON FREQUENCY SAMPLING, filed January 14, 1998, will now be described. The approach followed by the digital frequency discriminator of the present invention may be appreciated by analogy to Sigma-Delta A/D conversion, well-documented in the prior art by such references as "Oversampling Delta-Sigma Data Converters", Candy, et al., IEEE Press, pages 1-6, Piscataway, NJ (1992). A Sigma-Delta converter modulates a varying-amplitude analog input signal into a simple digital code at a frequency much higher than the Nyquist rate. The design of the modulator allows resolution in time to be traded for resolution in amplitude. A sampled-data circuit model of a Sigma-Delta modulator, shown in Figure 1, may be directly applied to frequency sampling as described herein.

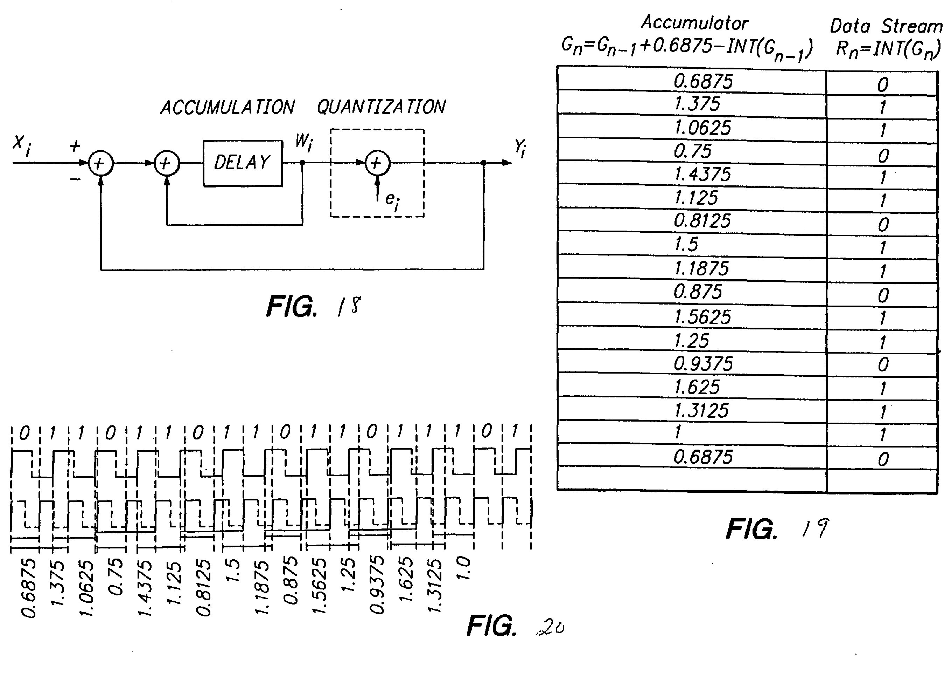

Referring to Figure 18, an input signal $x_i$ occurring at sample time i has subtracted from it the output signal $y_i$ at sample time i. The result is applied to an accumulator having an output signal $w_i$. A "new" input signal of the accumulator at sample time i is combined with the "old" output signal of the accumulator to form a new output signal of the accumulator. The output signal of the accumulator is quantized, the quantization being represented as the addition of an error $e_i$. The output signal of the quantizer is the final output signal $y_i$.

Assume now that $x_i$ is the ratio of two frequencies and that the quantizer is a two-level quantizer. Further assume that the ratio of the two frequencies for the time period in question is, say, 0.6875. As shown in Figure 19, the latter value is accumulated a first time, giving an accumulated value of 0.6875. This valuing being less than 1, the value 0.6875 is again added to the accumulated value, giving a new accumulated value of 1.375. Since this value is now greater than 1, 1 is subtracted from 0.6875 and the result (0.6875 - 1= -0.3125) added to the accumulator to give a value of 1.0625. Operation proceeds in this fashion. During the foregoing sequence of operations, a data stream is produced by taking the integer portion, 1 or 0, of each accumulated value.

Referring to Figure 20, the interpretation of the sequence of numbers shown in Figure 19 may be appreciated. Two clock signals are shown. Again, it is assumed that the ratio of the frequency of the upper clock signal to that of the lower clock signal during the period of interest is 0.6875. At time t = 0, rising edges of both clock signals coincide. At the first subsequent rising edge of the lower clock signal, 0.6875 periods of the upper clock signal have elapsed. At the next rising edge of the lower clock signal, 1.375 periods of the upper clock signal have elapsed. At the next rising edge of the lower clock signal, 1.0625 periods of the upper clock signal have elapsed since the elapse of the first period of the upper clock signal, and so on.

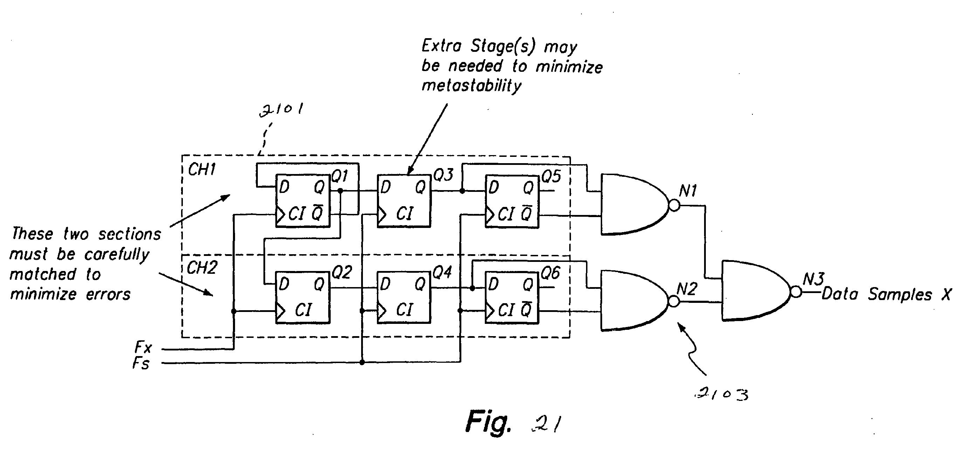

A schematic diagram of a capture circuit, or frequency sampling circuit, that may be used to data samples corresponding to the data stream described in the foregoing example is shown in Figure 21. In the illustrated embodiment, it is assumed that the ratio of the clock signals is such that no more than one rising edge of the faster clock will occur during a single period of the slower clock. In other embodiments, this assumption need not apply.

The capture circuit includes a input portion 2101 and an output portion 2103. The input portion includes two sections Ch1 and Ch2 that must be carefully matched to minimize errors. Each section comprises a chain of two or more D flip-flops coupled in series. In the following description, the same reference numerals will be used to reference the respective flip-flops themselves and their respective output signals.

Within each section, the first flip-flop in the chain is clocked by a sampled clock signal Fx. The succeeding flip-flops in the chain are clocked by a sampling clock signal Fs. The D input of the first flip-flop Q1 in the upper section is coupled to the $\overline{Q}$ output of the same. The D input of the first flip-flop in the lower section is coupled to the Q output of the first flip-flop in the upper section. The remaining flip-flops in both sections are coupled in series--i.e., Q to D, Q to D.

The function of the input portion is to 1) produce two signals, logical inverses of one another, that transition on rising edges of the clock signal Fx; 2) to latch the values of the two signals on the rising edge of the clock signal Fs; and 3) to detect transitions from one clock to the next. Additional intermediate stages in series with Q3 and Q4 may be required to minimize metastability resulting from the asynchrony of the two clock signals, and in fact multiple such stages may be desirable in a particular design.

The output portions include, in an exemplary embodiment, three two-input NAND gates. Respective NAND gates N1 and N2 are coupled to the D and $\overline{Q}$ signal of the final flip-flop stages of the input sections. Output signals of the NAND gates N1 and N2 are combined in the further NAND gate N3 to form the final output of the capture circuit.

The function of the output portion is to detect a change in the input clock signal level from one sample clock to the next in either of two channels formed by the two input sections. The two input sections function in a ping-pong fashion, alternately detecting changes in the input clock signal level.

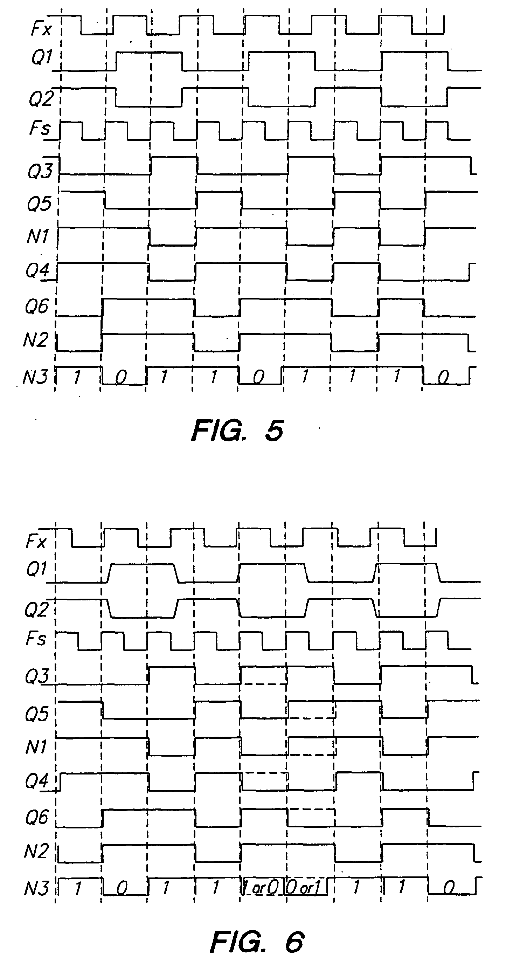

Operation of the capture circuit of Figure 21 may be more fully appreciated with reference to the timing diagram of Figure 5. The first stages of the two channels form inverse signals Q1 and Q2 approximately coincident with (but slightly delayed from) rising edges of the input clock signal. The signals Q3 and Q4 are formed by sampling the signals Q1 and Q2, respectively, in accordance with the sample clock. The signals Q5 and Q6, respectively, are delayed replicas of the signals Q3 and Q4. The NAND gates together realize the logic function $X = Q3 \cdot \overline{Q5} \vee Q4 \cdot \overline{Q6}$.

In the example of Figure 5, the illustrated signals are all idealized square-wave signals. In actuality, the signals will have finite rise and fall times. The possible effect of the finite rise and fall times of the signals Q1 and Q2 and the asynchrony of the circuit is metastability, as illustrated in Figure 6. Here, the signals Q3 and Q5 and the signals Q4 and Q6 are each in an indeterminate state for one cycle. The resulting output of the circuit may or may not be correct. However, because the decision was a "close call" to begin with, the effect of an occasional erroneous decision on the overall operation of the circuit is negligible. The time window of instability is reduced by increasing the overall gain in the path. If the gain in Q3 and Q9 is sufficient to reduce the probability of an error to an acceptable level, then no additional circuitry is required. If not, then additional circuitry will be required to increase the gain.

In order to recover the ratio of the frequencies of the two clock signals from the data stream produced by a capture circuit such as the one of Figure 21, digital filtering is applied. Advantageously, an extensive body of digital filtering techniques applicable to Sigma-Delta (or Delta-Sigma) A/D converters may be applied directly to the digital stream. Furthermore, by using an appropriately-chosen weighting function, high accuracy may be obtained.

The weighted sum of products is an example of an FIR filter. The weighting function described heretofore is therefore that of an FIR filter in digital filtering theory. It should be recognized, however, that IIR filters can also be used. In the process of FIR digital filtering, the weighting function is applied to a "window" of data samples to obtain an estimate of the ratio of frequencies in the center of the window. The window is then "picked up and moved" to the next sequence of samples. Windowing will typically overlap. A window may include 256 samples, for example.

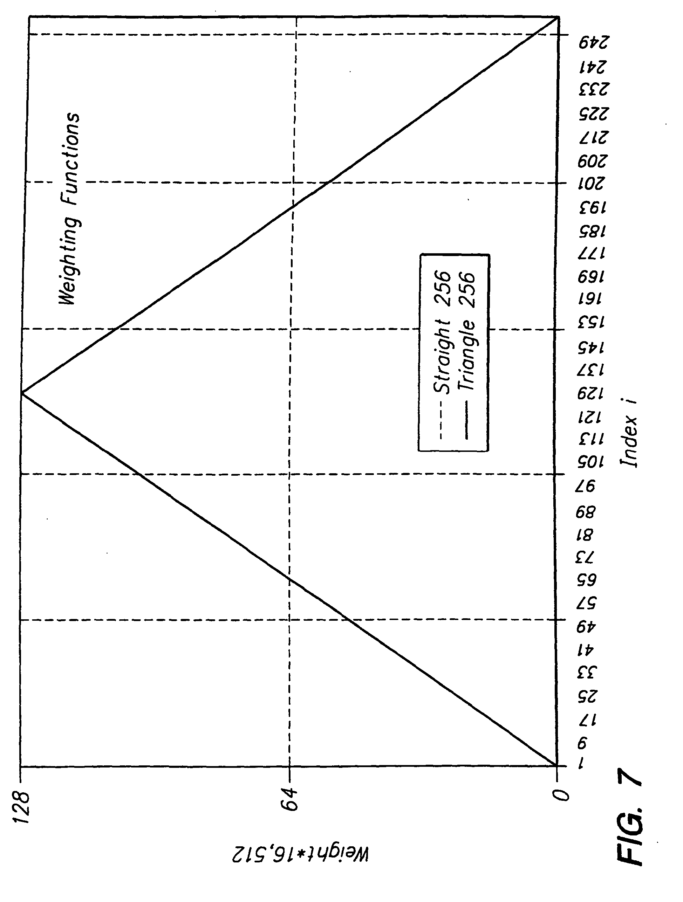

Referring to Figure 7, two alternative weighting functions are shown for a window of 256 samples. The weighting functions are normalized, meaning that the area under the weighting function is unity. One weighting function, indicated in dashed lines, is a straight-line, constant weighting function. Another weighting function, indicated in solid line, is a triangular weighting function. The weighting function is the impulse response function in digital filters.

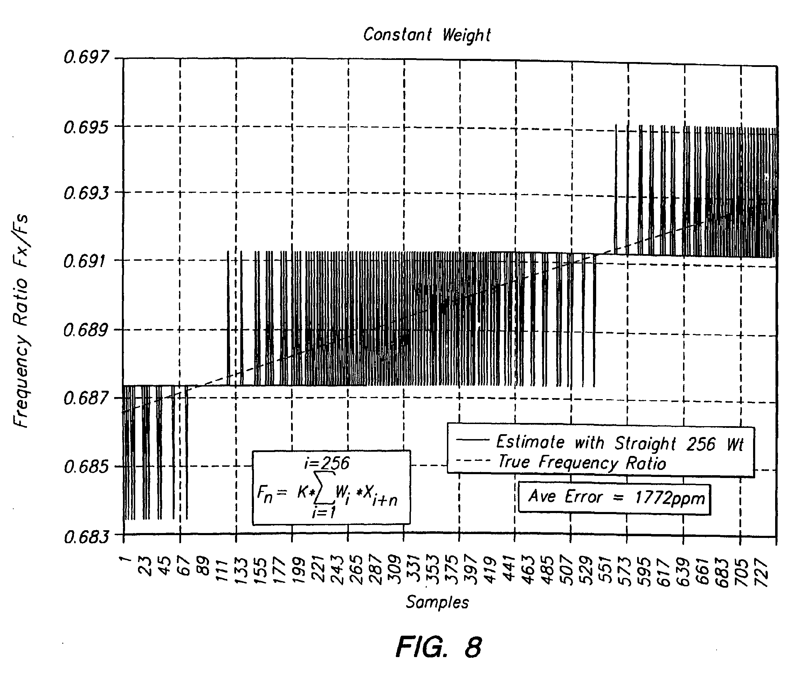

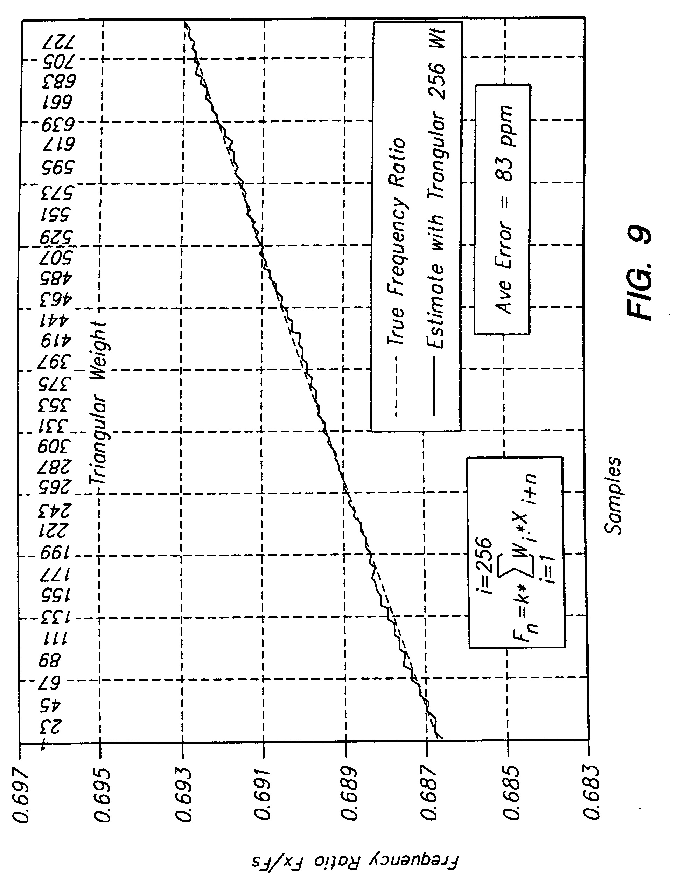

Results of digital filtering using the straight-line weighting function and the triangular weighting function respectively, are shown in Figure 8 and Figure 9. In the case of both Figure 8 and Figure 9, the frequency ratio was increased from just under 0.687 to just over 0.693. As seen in Figure 8, using a straight-line weighting function, the quantized signal oscillates between two levels that are adjacent to the input in such a manner that its local average equals the average input. The average error was calculated to be 1772ppm. As seen in Figure 9, using a triangular weighting function, the quantized signal tracks the input with an average error of 83ppm.

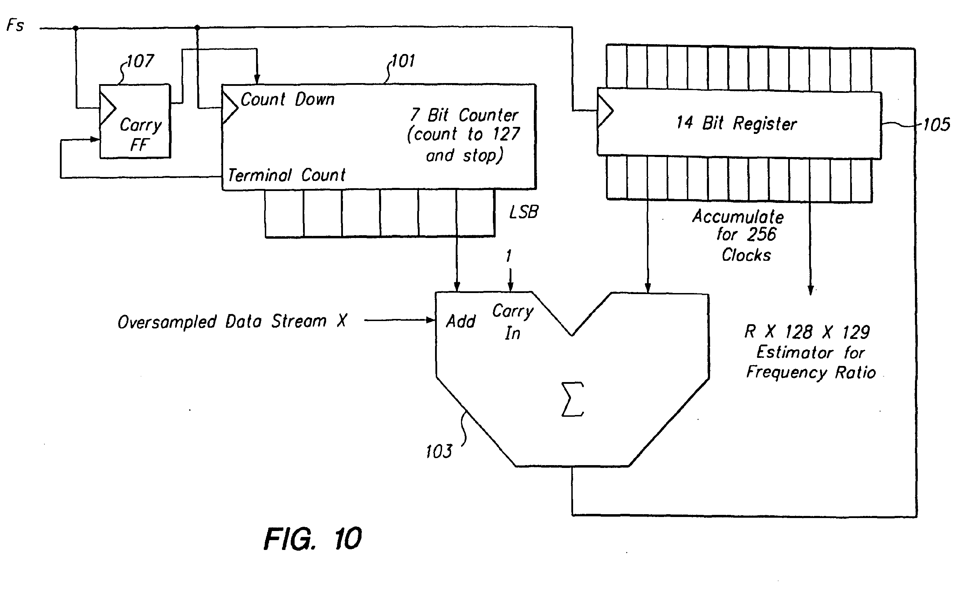

A schematic diagram of an exemplary frequency accumulator that applies a triangular weighting function and that may be used to accomplish the desired digital filtering is shown in Figure 10. In the example shown, the frequency accumulator uses a 7-bit counter 101, a 14-bit adder 103 and a 14-bit register 105. The 7-bit counter is clocked by the sample frequency Fs. The output of the 7-bit counter is provided to one input of the adder. The function of the 7-bit counter is to count up from 0 to 127 and then down from 127 to 0. The count of 127 occurs twice in succession. This behavior is achieved using a flip-flop 107. The flip-flop is clocked by the sample frequency Fs. A Terminal Count signal of the 7-bit adder is input to the flip-flop. The output of the flip-flop is coupled to a Count Down input of the 7-bit counter.

The "oversampled" data stream is coupled to a control input of the adder. When the current bit of the data stream is a 1, an addition is performed. When the current bit is a 0, no addition is performed. A Carry In input of the adder is tied high, effectively causing the range of weights to be 1 to 128.

The 14-bit register is clocked by the sample frequency Fs. Its output is applied to the other input of the adder. Its input receives the output word produced by the adder. The function of the 14-bit adder is to perform an accumulation operation for 256 clocks. At the conclusion of the 256 clocks, the output of the 14-bit adder is used as an estimator for the frequency ratio. More particularly, in the example shown, the output of the accumulator is equal to $R \times 128 \times 129$, where R is the frequency ratio estimator.

The foregoing technique may be readily extended to phase discrimination. Various different methods and apparatus for digital phase discrimination will be described entailing different design tradeoffs.

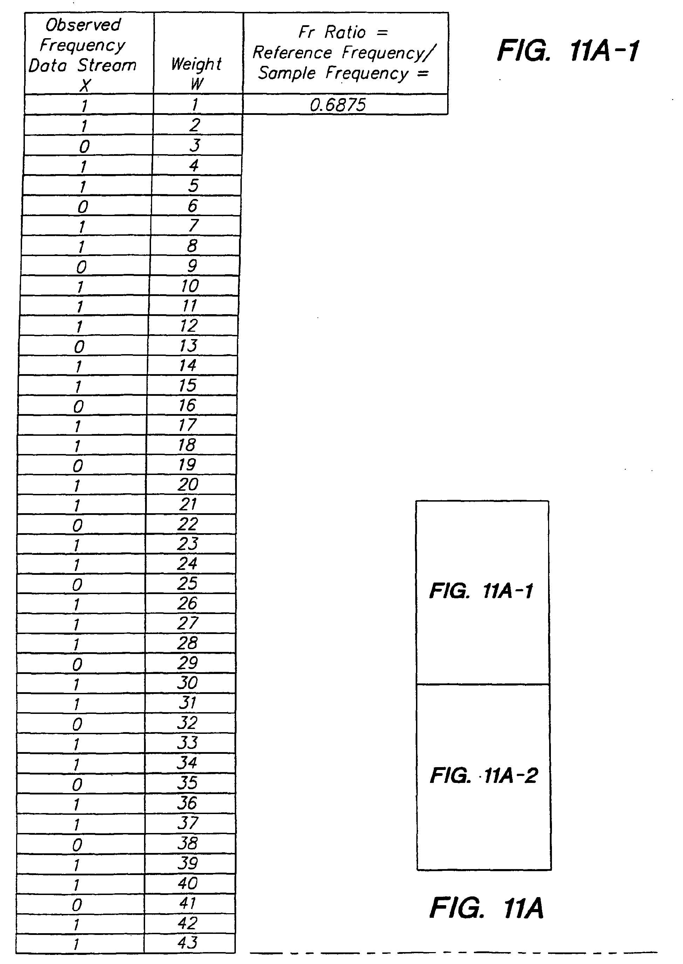

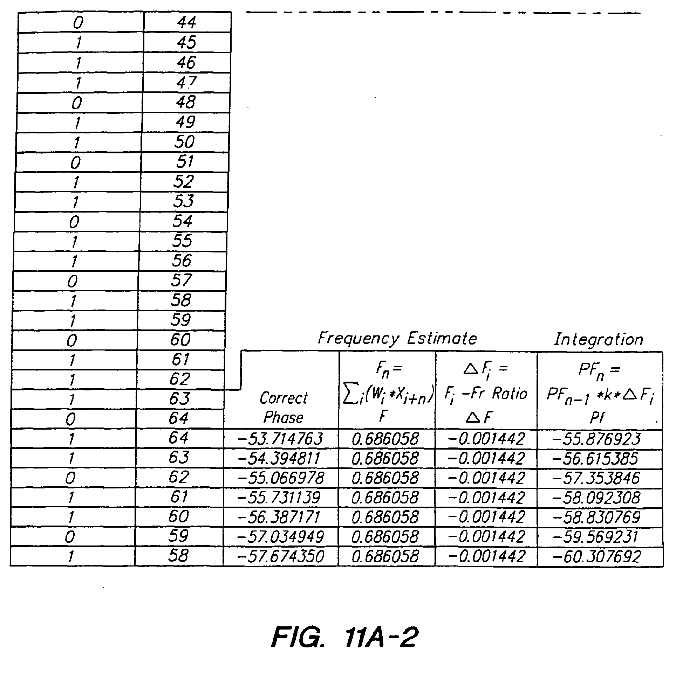

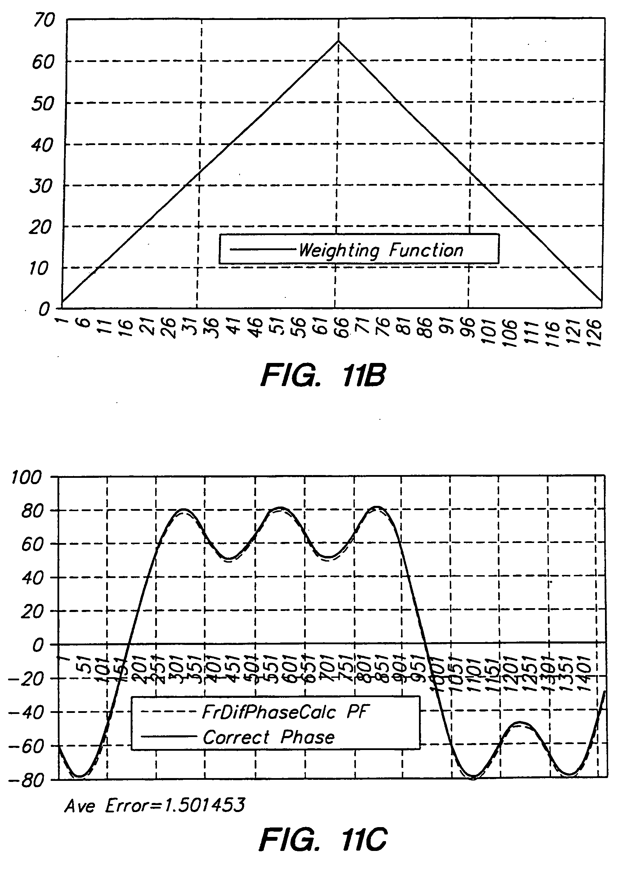

The first method is conceptually straightforward but computationally expensive. Referring to Figure 11A, the same observed frequency data stream and the same set of weights corresponding to a triangular weighting function (Fig. 11B) are used. The ratio of the reference frequency to the sampled frequency over a relatively long period of time is first determined using the technique described previously. Having obtained this frequency ratio estimator, short-term frequency deviations are estimated by calculating the same frequency estimate as before but at a relatively high rate, as often as once per sample period. That is, successive samples are all taken using the circuit of Figure 10, as often as each sample period. The difference ($\Delta F$) of each frequency estimate (F) from the previously-determined frequency ratio (Fr) is calculated, multiplied by an appropriate scale factor k and accumulated to obtain a corresponding phase estimate Pf. (The first value of Pf is an arbitrarily chosen initial condition, chosen for comparison to an ideal estimate. In practice, the phase may be initialized to a value based on a priori knowledge of signal characteristics, or, absent such a priori knowledge, may be set to zero upon detection of a phase inflection point.)

A phase-plot simulation comparing actual phase of a specified waveform (solid-line) with estimated phase using the foregoing phase estimation method (dashed-line) is shown in Fig. 11C.

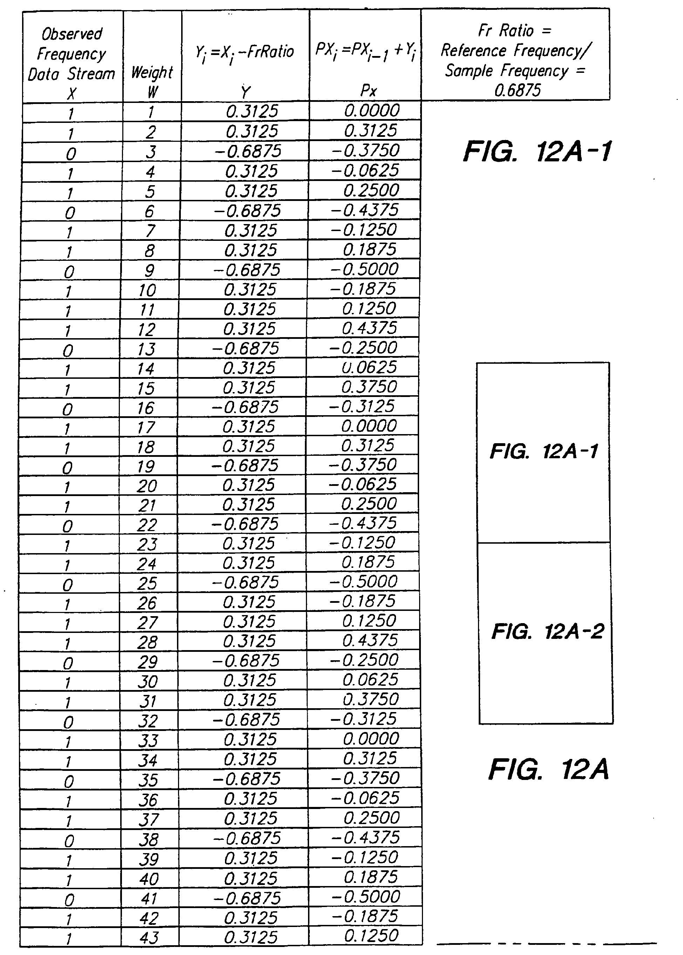

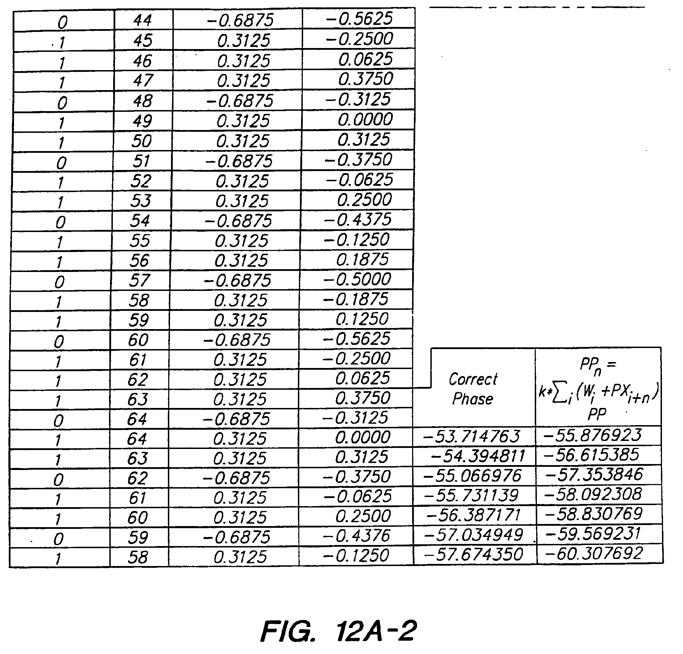

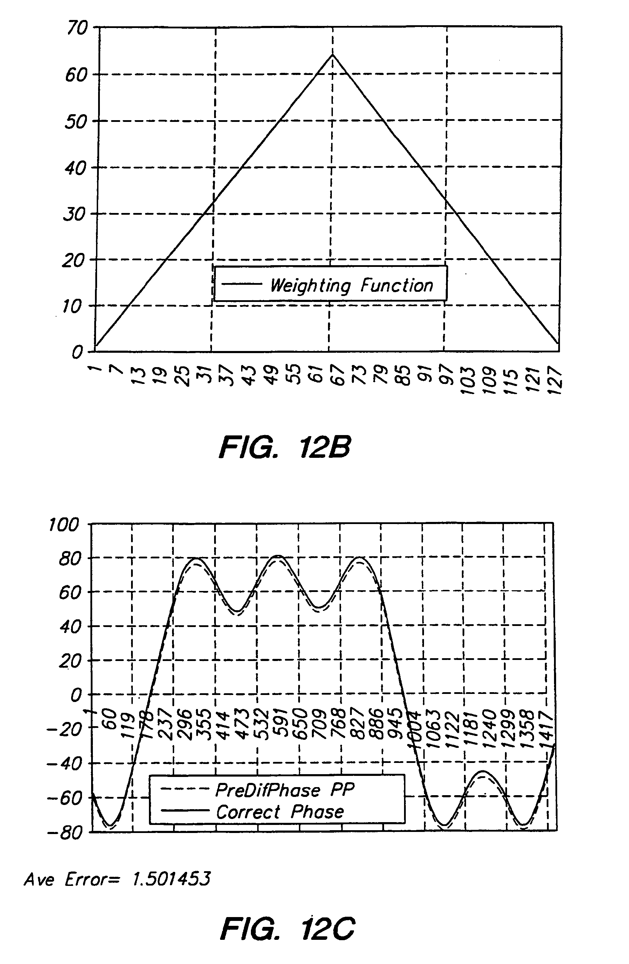

The foregoing "frequency difference" phase estimation method is computationally expensive because of the need to calculate frequency estimates at a relatively high rate. A "pre-summation difference" phase estimation method obviates this requirement. Referring to Figure 12A, instead of subtracting the frequency ratio from a frequency estimate, the frequency ratio Fr is subtracted from the sampled data stream itself. Assuming that the data stream is a bit stream of ones and zeros only, and assuming a frequency ratio Fr = 0.6875, then the pre-summation difference Y will have one of only two values, Y = 1 - 0.6875 = .3125 or Y = 0 - 0.6875 = - 0.6875. The Y values are accumulated to obtain corresponding values PX. Phase estimates $PP_n$ are obtained by filtering the PX values in substantially the same manner as described previously in relation to forming frequency estimates (using the identical weighting function, Fig. 12B, for example) with the exception that the filtered values are scaled by the scale-factor k.

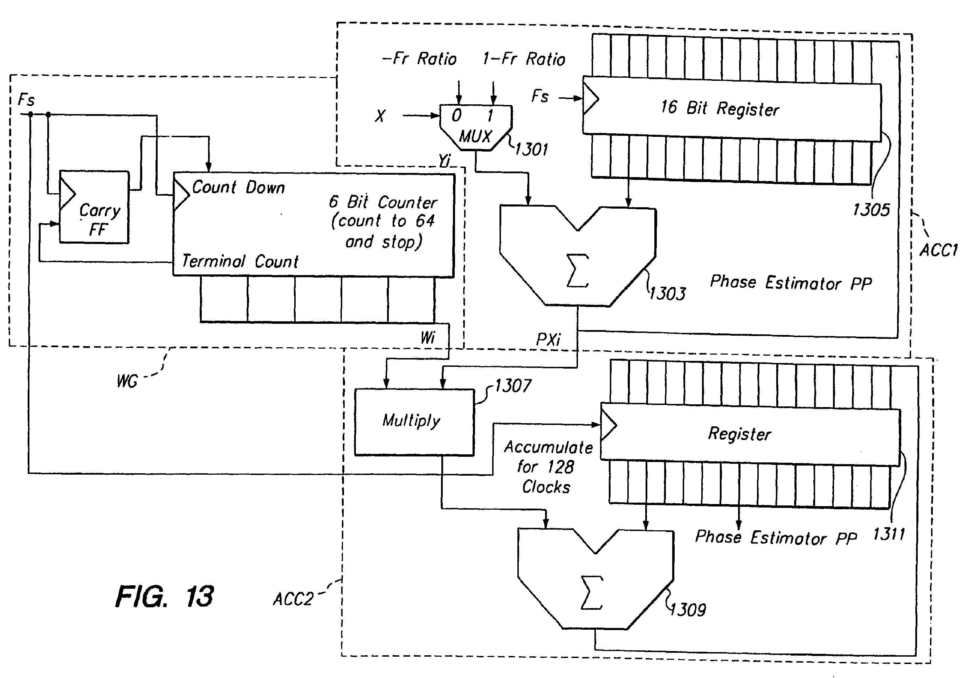

The pre-summation difference phase-calculation may be shown to be mathematically equivalent to the frequency difference phase calculation. Simulation results, shown in Fig. 12C, are therefore the same as in Fig. 11C. The hardware realization, however, may be considerably simpler using the pre-summation difference phase calculation, since only one computation is required per phase point. Such a hardware realization is shown in Figure 13.

The pre-summation difference phase estimator of Figure 13 includes generally a first accumulator ACC1, a weight generator WG similar or identical to the weight generator previously described in relation to Figure 10, and a second accumulator ACC2.

The accumulator ACC1 functions to produce phase numbers $PX_i$ in correspondence to bits (or in other embodiments, symbols) of the observed frequency data stream and includes a multiplexer 1301, an adder 1303 and a register (e.g., a 16-bit register) 1305. The multiplexer 1301 selects one of the two possible values of $Y_i$ in accordance with the value of X and applies $Y_i$ to the adder 1303. The register value is added to $Y_i$ to form $PX_i$, which is then strobed into the register. The adder 1303 and register 1305 therefore accumulate the $PX_i$ values.

The $PX_i$ values are then filtered in the accumulator ACC2, which includes a multiplier 1307, an adder 1309 and a register 1311. The multiplier receives weights from the weight generator WG and $PX_i$ values from the accumulator ACC1. Respective weights and $PX_i$ values are multiplied and the products accumulated, e.g., for 128 clock cycles, to produce a phase estimator PP. The multiplier may be constructed so as to apply the scale factor k to each product during the accumulation process.

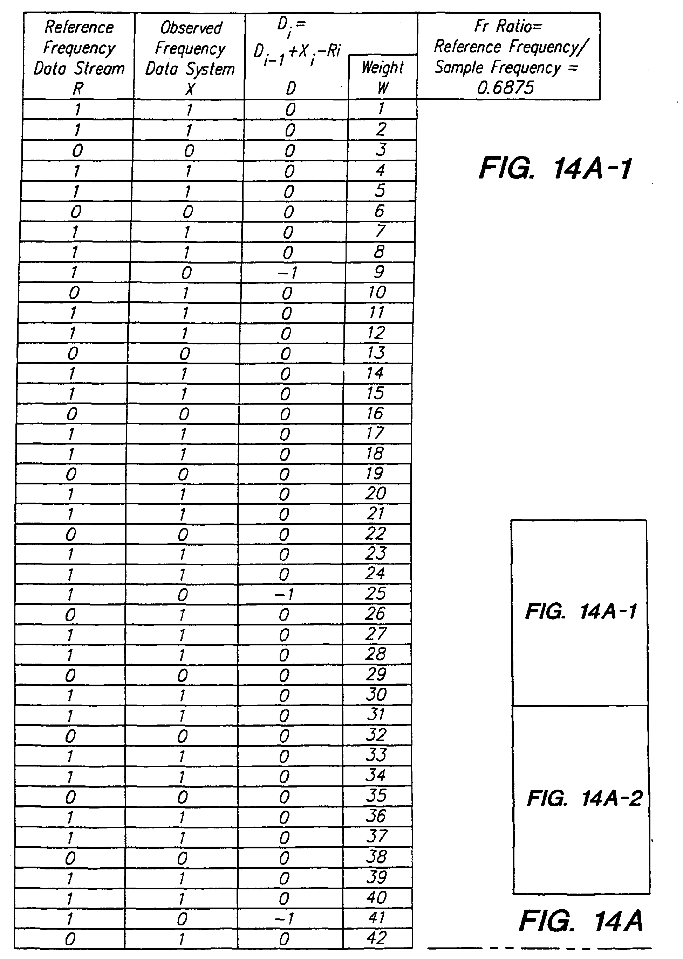

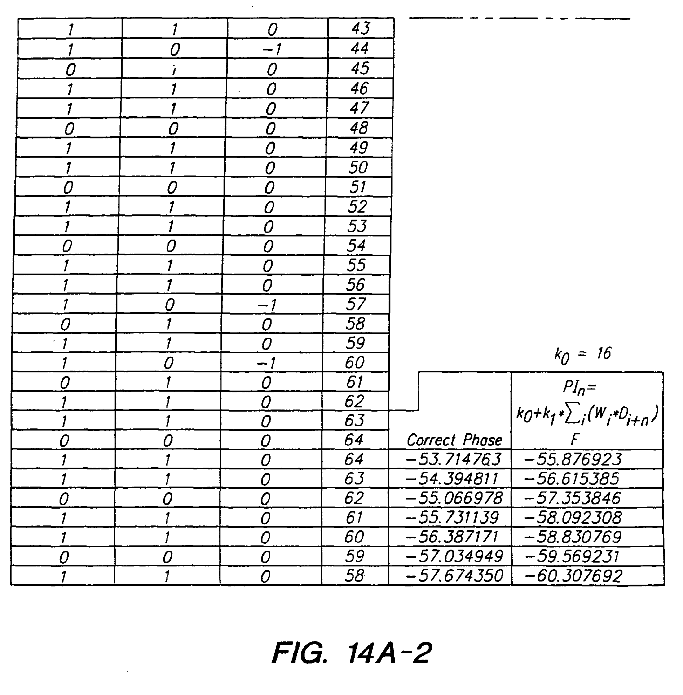

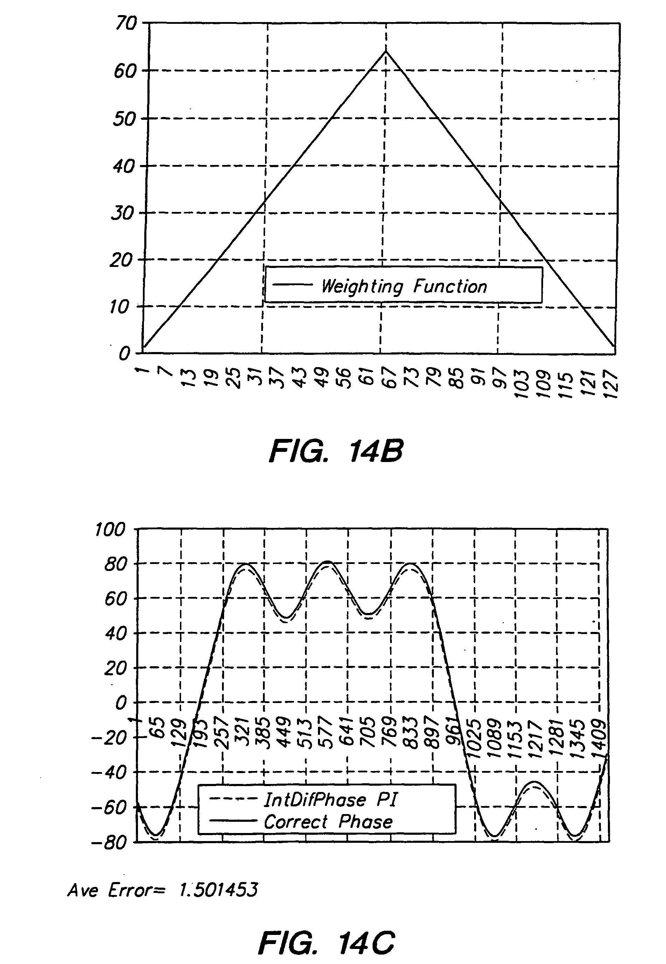

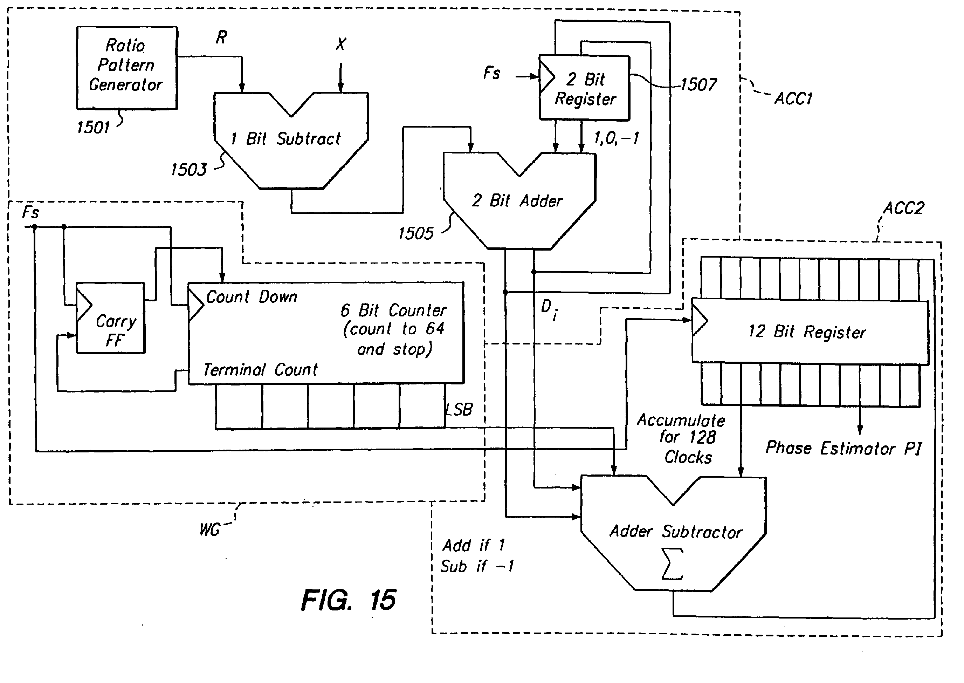

An even simpler realization may be achieved using an integer difference phase calculation. The integer difference phase calculation is not mathematically equivalent to the foregoing methods, but is very close. Referring to Fig. 14A, this method uses, in addition to the observed frequency data stream, a reference frequency data stream that would result if the reference frequency were applied to the capture circuit of Figure 4 (with the same clock). A running sum $D_i$ is then formed of the integer difference $X_i$-$R_i$. In many practical applications, such as the one illustrated in Figures 14 and 15, $D_i$ will have the values 1, 0 and -1 exclusively. The general case in which $D_i$ takes on other values may be appreciated and understood, however, from the present example, and is embraced by the present description.

Phase estimates are formed by filtering the $D_i$ values in the same or similar manner as previously described. The same triangular weighting function may be used Fig. 14B. The integer difference phase calculation method produces identical simulation results, Fig. 14C, as the preceding methods.

Referring to Figure 15, in the instance where D takes on the values 1, 0 and -1 exclusively, the corresponding hardware realization may be substantially simplified (as compared to that of Figure 13, for example).

The integer difference phase estimator of Fig. 15, like that of Fig. 13, includes generally a first accumulator ACC1, a weight generator WG, and a second accumulator ACC2. The accumulator ACC 1 is of considerably different construction than the corresponding structure of Figure 13. The accumulator ACC1 of Figure 15 includes a reference pattern generator 1501, a 1-bit subtractor 1503, a 2-bit adder 1505 and a 2-bit register 1507. The 1-bit subtractor subtracts respective R values from respective X values. The 2-bit adder and the register accumulate the resulting $D_i$ values which, as explained previously, may be constrained to 1, 0, -1 only.

The weight generator WG and the accumulator ACC2 are substantially the same as in Figure 13, described previously. However, because $D_i$ takes on the values 1, 0 and -1 exclusively, no multiplier is required. Instead, if $D_i$ =1, the weight value is added to the accumulated value, and if $D_i$ = -1, the weight value is subtracted. (If $D_i$ = 0, the accumulated value remains unchanged.) The savings of a hardware multiplier is a particular advantage of the implementation of Fig. 15.

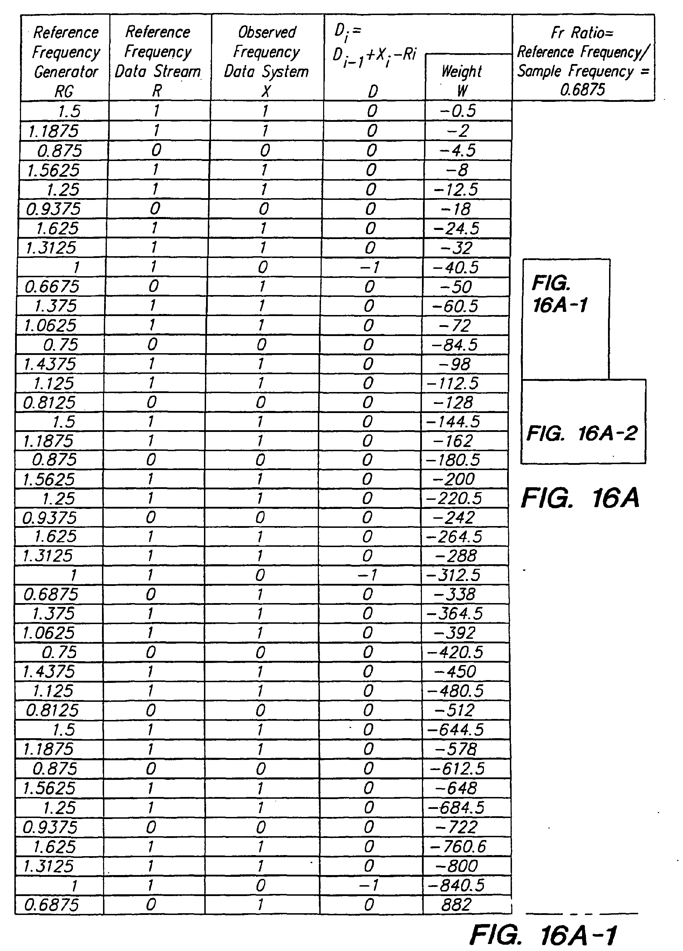

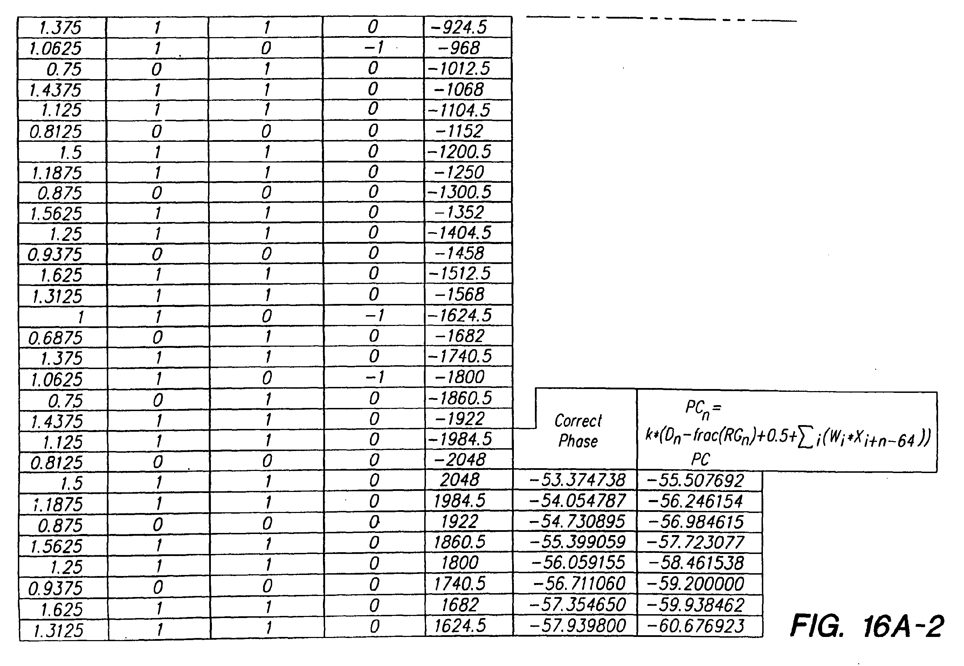

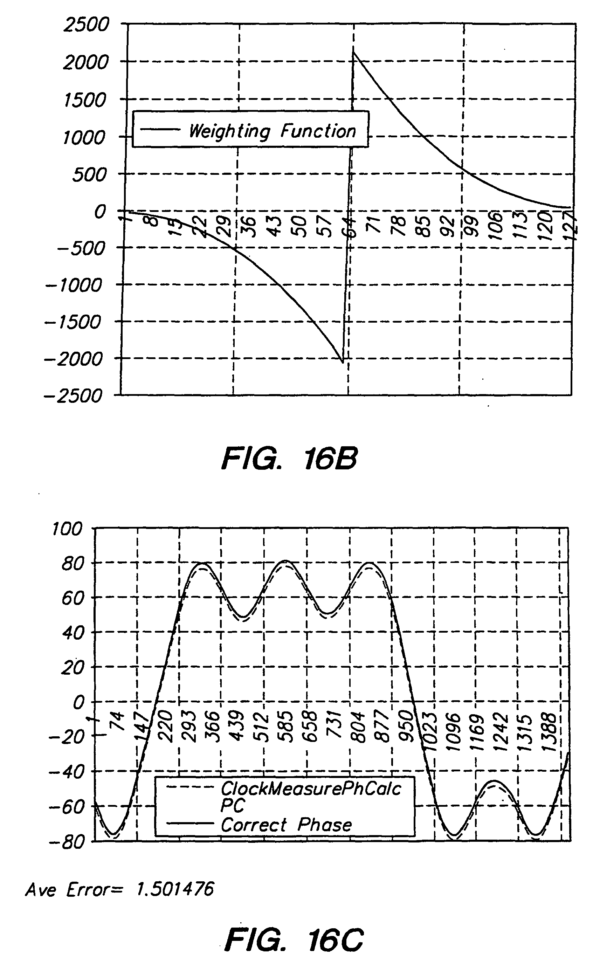

A further method of phase estimation is referred to as the clock measure phase calculation method. Referring to Figure 16A, this method is similar to the previous integer difference phase calculation method insofar as R, X and D are concerned. This method, however, uses in addition to the reference frequency data stream R, "clock measure" numbers RG, which are the same as the numbers appearing in Fig. 2. Moreover, the weight function used is distinctly different, as shown in Figure 16B. Clock measure phase estimate values PC are obtained using the following formula:

$$PC_n = k \cdot \left( D_n - fracRG_n + 0.5 + \sum_i (W_i \cdot X_{i+n-64}) \right)$$

Simulation results using the clock measure phase calculation method are shown in Figure 16C.

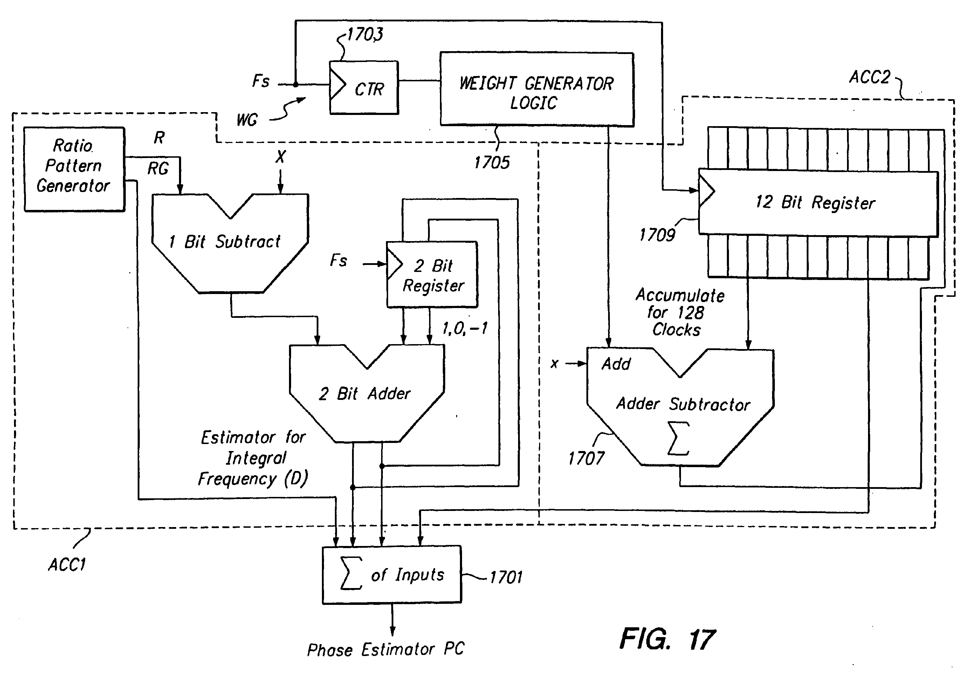

Referring to Figure 17, the clock measure phase estimator includes generally a first accumulator ACC1, a weight generator WG, and a second accumulator ACC2. The estimator additionally includes a summation block 1701.

The accumulator block ACC1 is substantially the same as the accumulator block ACC1 of Figure 15. Note, however, that the reference pattern generator generates both the reference frequency data stream R, used within the accumulator ACC 1, and the clock measure data stream RG which is input to the summation block 1701.

The weight generator includes a counter 1703 and weight generator logic 1705.

The accumulator ACC2 includes an adder 1707 and a register 1709. When X = 1, the weight value from the weight generator is added to the contents of the register 1709. The output of the adder becomes the new input of the register, which performs an accumulator operation for, e.g., 128 clock cycles.

At the conclusion of the accumulation operation of ACC2, the outputs of ACC 1 and ACC2, together with the corresponding RG value, are summed in the summation block 1701.

## Claims

**1.** An RF modulator comprising:

    a phase lock loop including a loop filter (403) and receiving as an input signal a baseband modulation signal and producing as an output signal a modulated RF signal;
circuitry for producing an injection modulation signal;
circuitry for injecting the injection modulation signal into the phase lock loop at a point past the loop filter; and
control circuitry, coupled to the circuitry for injection the injection modulation signal, for controlling the amplitude of the injection modulation signal, wherein said circuitry for injecting comprises an adaptive gain amplifier (411), and said control circuitry includes a phase demodulator (419).

2. The apparatus of Claim 1, wherein said phase demodulator (419) is digital.

3. The apparatus of Claim 2, wherein said control circuitry further comprises a comparison circuit (417).

4. The apparatus of Claim 3, wherein the comparison circuit (417) compares the baseband modulation signal to a phase information signal recovered by the phase demodulator (419) and produces an error signal.

5. The apparatus of Claim 4, wherein said error signal is used to set the gain of the adaptive gain amplifier (411).

6. The apparatus of Claim 1, further comprising a direct digital synthesis circuit (415) for receiving the baseband modulation signal, producing a corresponding modulated signal, and applying the modulated signal to the phase lock loop.

7. The apparatus of Claim 6, wherein the direct digital synthesis circuit (415) includes a number controlled modulated oscillator.

8. The apparatus of Claim 1, wherein said phase lock loop includes a divide by N counter (407).

9. The apparatus of Claim 1, wherein said phase lock loop includes a downconverter (420).

10. The apparatus of Claim 1, further comprising an amplitude modulation stage coupled to the output signal of the phase lock loop.

11. A method of producing precise, stable phase shifts in a modulated RF signal, comprising the steps of:

using a baseband modulation signal, producing a modulated signal;
applying the modulated signal as a reference signal to a phase lock; and
automatically deriving an adaptive gain factor and applying the adaptive gain factor to the baseband modulation signal to produce an injection signal and injecting the injection signal into the phase lock loop;

wherein the injection signal compensates for the phase lock loop partially removing modulation introduced by the baseband modulation signal.

12. The method of Claim 11, wherein automatically deriving an adaptive gain factor comprises:

recovering phase information from an output signal of the phase lock loop;
comparing the phase information to the baseband modulation signal and producing an error signal, the adaptive gain factor being derived from the error signal.

**Patentansprüche**

1. Radiofrequenz(RF)-Modulator, umfassend:

einen phasengekoppelten Regelkreis, welcher einen Tiefpass (403) enthält, und als ein Eingangssignal ein Basisbandmodulationssignal empfängt und als ein Ausgangssignal ein moduliertes RF-Signal herstellt;
eine Schaltung zum Herstellen eines Einkopplungsmodulationssignals;
eine Schaltung zum Einkoppeln des Einkopplungsmodulationssignals in den phasengekoppelten Regelkreis an einem Punkt nach dem Tiefpass; und
eine mit der Schaltung zum Einkoppeln des Einkopplungsmodulationssignals verbundene Steuerschaltung zum Steuern der Amplitude des Einkopplungsmodulationssignals, wobei die Schaltung zum Einkoppeln einen Verstärker (411) mit adaptiver Verstärkung umfasst, und wobei die Steuerschaltung einen Phasendemodulator (419) enthält.

2. Vorrichtung nach Anspruch 1, wobei der Phasendemodulator (419) digital ist.

3. Vorrichtung nach Anspruch 2, wobei die Steuerschaltung ferner eine Vergleichsschaltung (417) umfasst.

4. Vorrichtung nach Anspruch 3, wobei die Vergleichsschaltung (417) das Basisbandmodulationssignal mit einem durch den Phasendemodulator (419) zurückgewonnenen Phaseninformationssignal vergleicht und ein Fehlersignal herstellt.

5. Vorrichtung nach Anspruch 4, wobei das Fehlersignal verwendet wird, um die Verstärkung des Verstärkers (411) mit adaptiver Verstärkung einzustellen.

6. Vorrichtung nach Anspruch 1, ferner umfassend eine direkte digitale Syntheseschaltung (415) zum Empfangen des Basisbandmodulationssignals, zum Herstellen eines korrespondierenden modulierten Signals und zum Anlegen des modulierten Signals an den phasengekoppelten Regelkreis.

7. Vorrichtung nach Anspruch 6, wobei die direkte digitale Syntheseschaltung (415) einen numerisch gesteuerten modulierten Oszillator enthält.

8. Vorrichtung nach Anspruch 1, wobei der phasengekoppelte Regelkreis einen Teilen-durch-N-Zähler (407) enthält.

9. Vorrichtung nach Anspruch 1, wobei der phasengekoppelte Regelkreis einen Abwärtsumformer (420) enthält.

10. Vorrichtung nach Anspruch 1, ferner umfassend eine mit dem Ausgangssignal des phasengekoppelten Regelkreises verbundene Amplitudenmodulationsstufe.

11. Verfahren zum Herstellen genauer, stabiler Phasenverschiebungen in einem modulierten RF-Signal, umfassend die Schritte des:

Verwendens eines Basisbandmodulationssignals, Herstellens eines modulierten Signals;
Anlegens des modulierten Signals als ein Referenzsignal an eine Phasenkopplung; und
automatischen Ableitens eines adaptiven Verstärkungsfaktors und Anlegens des adaptiven Verstärkungsfaktors an das Basisbandmodulationssignal zum Herstellen eines Einkopplungssignals und Einkoppelns des Einkopplungssignals in den phasengekoppelten Regelkreis;

wobei das Einkopplungssignal das teilweise Entfernen der durch das Basisbandmodulationssignal eingeführten Modulation des phasengekoppelten Regelkreises kompensiert.

12. Verfahren nach Anspruch 11, wobei automatisches Ableiten eines adaptiven Verstärkungsfaktors umfasst:

Zurückgewinnen von Phaseninformationen von einem Ausgangssignal des phasengekoppelten Regelkreises;
Vergleichen der Phaseninformationen mit dem Basisbandmodulationssignal und Herstellen eines Fehlersignals, wobei der adaptive Verstärkungsfaktor aus dem Fehlersignal abgeleitet wird.

**Revendications**

1. Modulateur RF comprenant:

une boucle à verrouillage de phase incluant un filtre à boucle (403) et recevant comme un signal d'entrée un signal de modulation de bande de base et produisant comme un signal de sortie un signal RF modulé;
des circuits pour produire un signal de modulation d'injection;
des circuits pour injecter le signal de modulation d'injection dans la boucle à verrouillage de phase à un point après le filtre à boucle; et
des circuits de commande, couplés aux circuits pour injecter le signal de modulation d'injection, afin de commander l'amplitude du signal de modulation d'injection, où lesdits circuits pour l'injection comprennent un amplificateur à gain adaptatif (411) et lesdits circuits de commande incluent un démodulateur de phase (419).

2. Appareil de la revendication 1, dans lequel ledit démodulateur de phase (419) est numérique.

3. Appareil de la revendication 2, dans lequel lesdits circuits de commande comprennent en plus un circuit de comparaison (417).

4. Appareil de la revendication 3, dans lequel le circuit de comparaison (417) compare le signal de modulation de bande de base à un signal d'information de phase récupéré par le démodulateur de phase (419) et produit un signal d'erreur.

5. Appareil de la revendication 4, dans lequel ledit signal d'erreur est utilisé pour régler le gain de l'amplificateur à gain adaptatif (411).

6. Appareil de la revendication 1, comprenant en plus un circuit de synthèse numérique direct (415) pour recevoir le signal de modulation de bande de base, produisant un signal modulé correspondant, et appliquant le signal modulé à la boucle à verrouillage de phase.

7. Appareil de la revendication 6, dans lequel le circuit de synthèse numérique direct (415) inclut un oscillateur modulé à commande numérique.

8. Appareil de la revendication 1, dans lequel ladite boucle à verrouillage de phase inclut un compteur à division par N (407).

9. Appareil de la revendication 1, dans lequel ladite boucle à verrouillage de phase inclut un convertisseur-abaisseur (420).

10. Appareil de la revendication 1, comprenant en plus un étage de modulation d'amplitude couplé au signal de sortie de la bouche à verrouillage de phase.

11. Procédé pour produite des changements de phase stables et précis dans un signal RF modulé, comprenant les étapes consistant à:

utiliser un signal de modulation de bande de base, produisant un signal modulé;
appliquer le signal modulé comme un signal de référence à une boucle de phase; et
dériver automatiquement un facteur de gain adaptatif et appliquer le facteur de gain adaptatif au signal de modulation de bande de base pour produire un signal d'injection et injecter le signal d'injection dans la boucle à verrouillage de phase;

où le signal d'injection compense partiellement la boucle à verrouillage de phase en éliminant une modulation introduite par le signal de modulation de bande de base.

12. Procédé de la revendication 11, dans lequel le fait de dériver automatiquement un facteur de gain adaptatif comprend:

récupérer une information de phase à partir d'un signal de sortie de la boucle à verrouillage de phase;
comparer l'information de phase au signal de modulation de bande de base et produire un signal d'erreur, le facteur de gain adaptatif étant dérivé du signal d'erreur.

FIG 1. PRIOR ART

Cos $(w_c t + \phi(t))$ → [201 $\phi$] → [203 LOOP FILTER] → [205 VCO] → Cos $(N w_c t + N\phi(t))$

[207 $\div N$]

FIG 2

PRIOR ART

MOD → [309 VCXO] → [301 $\phi$] → [303 LOOP FILTER] → [313 +] → [305 VCO] →

[311]

[307 $\div N$]

FIG 3

PRIOR ART

FIG 4

$$S(t) = A(t) \cos(\omega_c t + \phi(t))$$

EP 1 057 252 B1

**FIG. 5**

**FIG. 6**

FIG. 7

Constant Weight

$$F_n = K * \sum_{i=1}^{i=256} W_i * X_{i+n}$$

—— Estimate with Straight 256 Wt
----- True Frequency Ratio

Ave Error = 1772ppm

FIG. 8

EP 1 057 252 B1

FIG. 9

FIG. 10

| Observed Frequency Data Stream X | Weight W | Fr Ratio = Reference Frequency/ Sample Frequency = |
|---|---|---|
| 1 | 1 | 0.6875 |
| 1 | 2 | |
| 0 | 3 | |
| 1 | 4 | |
| 1 | 5 | |
| 0 | 6 | |
| 1 | 7 | |
| 1 | 8 | |
| 0 | 9 | |
| 1 | 10 | |
| 1 | 11 | |
| 1 | 12 | |
| 0 | 13 | |
| 1 | 14 | |
| 1 | 15 | |
| 0 | 16 | |
| 1 | 17 | |
| 1 | 18 | |
| 0 | 19 | |
| 1 | 20 | |
| 1 | 21 | |
| 0 | 22 | |
| 1 | 23 | |
| 1 | 24 | |
| 0 | 25 | |
| 1 | 26 | |
| 1 | 27 | |
| 1 | 28 | |
| 0 | 29 | |
| 1 | 30 | |
| 1 | 31 | |
| 0 | 32 | |
| 1 | 33 | |
| 1 | 34 | |
| 0 | 35 | |
| 1 | 36 | |
| 1 | 37 | |
| 0 | 38 | |
| 1 | 39 | |
| 1 | 40 | |
| 0 | 41 | |
| 1 | 42 | |
| 1 | 43 | |

*FIG. 11A-1*

*FIG. 11A-1*

*FIG. 11A-2*

*FIG. 11A*

| | |
|---|---|
| 0 | 44 |
| 1 | 45 |
| 1 | 46 |
| 1 | 47 |
| 0 | 48 |
| 1 | 49 |
| 1 | 50 |
| 0 | 51 |
| 1 | 52 |
| 1 | 53 |
| 0 | 54 |
| 1 | 55 |
| 1 | 56 |
| 0 | 57 |
| 1 | 58 |
| 1 | 59 |
| 0 | 60 |
| 1 | 61 |
| 1 | 62 |
| 1 | 63 |
| 0 | 64 |

| | | Frequency Estimate | | Integration |
|---|---|---|---|---|
| Correct Phase | | $F_n = \sum_i (W_i * X_{i+n})$ <br> $F$ | $\Delta F_i = F_i - Fr$ Ratio <br> $\Delta F$ | $PF_n = PF_{n-1} * k * \Delta F_i$ <br> $Pf$ |
| 1 | 64 | −53.714763 | 0.686058 | −0.001442 | −55.876923 |
| 1 | 63 | −54.394811 | 0.686058 | −0.001442 | −56.615385 |
| 0 | 62 | −55.066978 | 0.686058 | −0.001442 | −57.353846 |
| 1 | 61 | −55.731139 | 0.686058 | −0.001442 | −58.092308 |
| 1 | 60 | −56.387171 | 0.686058 | −0.001442 | −58.830769 |
| 0 | 59 | −57.034949 | 0.686058 | −0.001442 | −59.569231 |
| 1 | 58 | −57.674350 | 0.686058 | −0.001442 | −60.307692 |

## FIG. 11A-2

**FIG. 11B**

Ave Error=1.501453

**FIG. 11C**

| Observed Frequency Data Stream X | Weight W | $Y_i = X_i - FrRatio$ Y | $PX_i = PX_{i-1} + Y_i$ Px | Fr Ratio = Reference Frequency/ Sample Frequency = 0.6875 |
|---|---|---|---|---|
| 1 | 1 | 0.3125 | 0.0000 | |
| 1 | 2 | 0.3125 | 0.3125 | |
| 0 | 3 | −0.6875 | −0.3750 | |
| 1 | 4 | 0.3125 | −0.0625 | |
| 1 | 5 | 0.3125 | 0.2500 | |
| 0 | 6 | −0.6875 | −0.4375 | |
| 1 | 7 | 0.3125 | −0.1250 | |
| 1 | 8 | 0.3125 | 0.1875 | |
| 0 | 9 | −0.6875 | −0.5000 | |
| 1 | 10 | 0.3125 | −0.1875 | |
| 1 | 11 | 0.3125 | 0.1250 | |
| 1 | 12 | 0.3125 | 0.4375 | |
| 0 | 13 | −0.6875 | −0.2500 | |
| 1 | 14 | 0.3125 | 0.0625 | |
| 1 | 15 | 0.3125 | 0.3750 | |
| 0 | 16 | −0.6875 | −0.3125 | |
| 1 | 17 | 0.3125 | 0.0000 | |
| 1 | 18 | 0.3125 | 0.3125 | |
| 0 | 19 | −0.6875 | −0.3750 | |
| 1 | 20 | 0.3125 | −0.0625 | |
| 1 | 21 | 0.3125 | 0.2500 | |
| 0 | 22 | −0.6875 | −0.4375 | |
| 1 | 23 | 0.3125 | −0.1250 | |
| 1 | 24 | 0.3125 | 0.1875 | |
| 0 | 25 | −0.6875 | −0.5000 | |
| 1 | 26 | 0.3125 | −0.1875 | |
| 1 | 27 | 0.3125 | 0.1250 | |
| 1 | 28 | 0.3125 | 0.4375 | |
| 0 | 29 | −0.6875 | −0.2500 | |
| 1 | 30 | 0.3125 | 0.0625 | |
| 1 | 31 | 0.3125 | 0.3750 | |
| 0 | 32 | −0.6875 | −0.3125 | |
| 1 | 33 | 0.3125 | 0.0000 | |
| 1 | 34 | 0.3125 | 0.3125 | |
| 0 | 35 | −0.6875 | −0.3750 | |
| 1 | 36 | 0.3125 | −0.0625 | |
| 1 | 37 | 0.3125 | 0.2500 | |
| 0 | 38 | −0.6875 | −0.4375 | |
| 1 | 39 | 0.3125 | −0.1250 | |
| 1 | 40 | 0.3125 | 0.1875 | |
| 0 | 41 | −0.6875 | −0.5000 | |
| 1 | 42 | 0.3125 | −0.1875 | |
| 1 | 43 | 0.3125 | 0.1250 | |

**FIG. 12A-1**

FIG. 12A-1

FIG. 12A-2

**FIG. 12A**

| | | | | Correct Phase | $PP_n = \dfrac{k*\sum_i (W_i + PX_{i+n})}{PP}$ |
|---|---|---|---|---|---|
| 0 | 44 | −0.6875 | −0.5625 | | |
| .1 | 45 | 0.3125 | −0.2500 | | |
| 1 | 46 | 0.3125 | 0.0625 | | |
| 1 | 47 | 0.3125 | 0.3750 | | |
| 0 | 48 | −0.6875 | −0.3125 | | |
| 1 | 49 | 0.3125 | 0.0000 | | |
| 1 | 50 | 0.3125 | 0.3125 | | |
| 0 | 51 | −0.6875 | −0.3750 | | |
| 1 | 52 | 0.3125 | −0.0625 | | |
| 1 | 53 | 0.3125 | 0.2500 | | |
| 0 | 54 | −0.6875 | −0.4375 | | |
| 1 | 55 | 0.3125 | −0.1250 | | |
| 1 | 56 | 0.3125 | 0.1875 | | |
| 0 | 57 | −0.6875 | −0.5000 | | |
| 1 | 58 | 0.3125 | −0.1875 | | |
| 1 | 59 | 0.3125 | 0.1250 | | |
| 0 | 60 | −0.6875 | −0.5625 | | |
| 1 | 61 | 0.3125 | −0.2500 | | |
| 1 | 62 | 0.3125 | 0.0625 | | |
| 1 | 63 | 0.3125 | 0.3750 | | |
| 0 | 64 | −0.6875 | −0.3125 | | |
| 1 | 64 | 0.3125 | 0.0000 | −53.714763 | −55.876923 |
| 1 | 63 | 0.3125 | 0.3125 | −54.394811 | −56.615385 |
| 0 | 62 | −0.6875 | −0.3750 | −55.066976 | −57.353846 |
| 1 | 61 | 0.3125 | −0.0625 | −55.731139 | −58.092308 |
| 1 | 60 | 0.3125 | 0.2500 | −56.387171 | −58.830769 |
| 0 | 59 | −0.6875 | −0.4376 | −57.034949 | −59.569231 |
| 1 | 58 | 0.3125 | −0.1250 | −57.674350 | −60.307692 |

## FIG. 12A-2

23

FIG. 12B

Ave Error= 1.501453

FIG. 12C

FIG. 13

| Reference Frequency Data Stream R | Observed Frequency Data System X | $D_i = D_{i-1} + X_i - R_i$ D | Weight W | Fr Ratio= Reference Frequency/ Sample Frequency = 0.6875 |
|---|---|---|---|---|
| 1 | 1 | 0 | 1 | |
| 1 | 1 | 0 | 2 | |
| 0 | 0 | 0 | 3 | |
| 1 | 1 | 0 | 4 | |
| 1 | 1 | 0 | 5 | |
| 0 | 0 | 0 | 6 | |
| 1 | 1 | 0 | 7 | |
| 1 | 1 | 0 | 8 | |
| 1 | 0 | −1 | 9 | |
| 0 | 1 | 0 | 10 | |
| 1 | 1 | 0 | 11 | |
| 1 | 1 | 0 | 12 | |
| 0 | 0 | 0 | 13 | |
| 1 | 1 | 0 | 14 | |
| 1 | 1 | 0 | 15 | |
| 0 | 0 | 0 | 16 | |
| 1 | 1 | 0 | 17 | |
| 1 | 1 | 0 | 18 | |
| 0 | 0 | 0 | 19 | |
| 1 | 1 | 0 | 20 | |
| 1 | 1 | 0 | 21 | |
| 0 | 0 | 0 | 22 | |
| 1 | 1 | 0 | 23 | |
| 1 | 1 | 0 | 24 | |
| 1 | 0 | −1 | 25 | |
| 0 | 1 | 0 | 26 | |
| 1 | 1 | 0 | 27 | |
| 1 | 1 | 0 | 28 | |
| 0 | 0 | 0 | 29 | |
| 1 | 1 | 0 | 30 | |
| 1 | 1 | 0 | 31 | |
| 0 | 0 | 0 | 32 | |
| 1 | 1 | 0 | 33 | |
| 1 | 1 | 0 | 34 | |
| 0 | 0 | 0 | 35 | |
| 1 | 1 | 0 | 36 | |
| 1 | 1 | 0 | 37 | |
| 0 | 0 | 0 | 38 | |
| 1 | 1 | 0 | 39 | |
| 1 | 1 | 0 | 40 | |
| 1 | 0 | −1 | 41 | |
| 0 | 1 | 0 | 42 | |

FIG. 14A-1

FIG. 14A-1

FIG. 14A-2

FIG. 14A

| | | | | Correct Phase | $PI_n = \dfrac{k_0 + k_1 * \sum_i (W_i * D_{i+n})}{F}$ |
|---|---|---|---|---|---|
| 1 | 1 | 0 | 43 | | |
| 1 | 0 | −1 | 44 | | |
| 0 | i | 0 | 45 | | |
| 1 | 1 | 0 | 46 | | |
| 1 | 1 | 0 | 47 | | |
| 0 | 0 | 0 | 48 | | |
| 1 | 1 | 0 | 49 | | |
| 1 | 1 | 0 | 50 | | |
| 0 | 0 | 0 | 51 | | |
| 1 | 1 | 0 | 52 | | |
| 1 | 1 | 0 | 53 | | |
| 0 | 0 | 0 | 54 | | |
| 1 | 1 | 0 | 55 | | |
| 1 | 1 | 0 | 56 | | |
| 1 | 0 | −1 | 57 | | |
| 0 | 1 | 0 | 58 | | |
| 1 | 1 | 0 | 59 | | |
| 1 | 0 | −1 | 60 | | |
| 0 | 1 | 0 | 61 | | |
| 1 | 1 | 0 | 62 | | |
| 1 | 1 | 0 | 63 | | |
| 0 | 0 | 0 | 64 | | |
| 1 | 1 | 0 | 64 | −53.714763 | −55.876923 |
| 1 | 1 | 0 | 63 | −54.394811 | −56.615385 |
| 0 | 0 | 0 | 62 | −55.066978 | −57.353846 |
| 1 | 1 | 0 | 61 | −55.731139 | −58.092308 |
| 1 | 1 | 0 | 60 | −56.387171 | −58.830769 |
| 0 | 0 | 0 | 59 | −57.034949 | −59.569231 |
| 1 | 1 | 0 | 58 | −57.674350 | −60.307692 |

$k_0 = 16$

## FIG. 14A-2

27

**FIG. 14B**

Ave Error= 1.501453

**FIG. 14C**

FIG. 15

Ratio Pattern Generator 1501

1 Bit Subtract 1503

X

R

2 Bit Register 1507

Fs

2 Bit Adder 1505

1,0,-1

ACC1

$D_i$

6 Bit Counter (count to 64 and stop)

Count Down

Terminal Count

LSB

Carry FF

Fs

WG

12 Bit Register

ACC2

Phase Estimator PI

Accumulate for 128 Clocks

Adder Subtractor

Add if 1 Sub if -1

| Reference Frequency Generator RG | Reference Frequency Data Stream R | Observed Frequency Data System X | $D_i = D_{i-1} + X_i - R_i$ D | Weight W | Fr Ratio= Reference Frequency/ Sample Frequency = 0.6875 |
|---|---|---|---|---|---|
| 1.5 | 1 | 1 | 0 | −0.5 | |
| 1.1875 | 1 | 1 | 0 | −2 | |
| 0.875 | 0 | 0 | 0 | −4.5 | |
| 1.5625 | 1 | 1 | 0 | −8 | |
| 1.25 | 1 | 1 | 0 | −12.5 | |
| 0.9375 | 0 | 0 | 0 | −18 | |
| 1.625 | 1 | 1 | 0 | −24.5 | |
| 1.3125 | 1 | 1 | 0 | −32 | |
| 1 | 1 | 0 | −1 | −40.5 | |
| 0.6675 | 0 | 1 | 0 | −50 | |
| 1.375 | 1 | 1 | 0 | −60.5 | |
| 1.0625 | 1 | 1 | 0 | −72 | |
| 0.75 | 0 | 0 | 0 | −84.5 | |
| 1.4375 | 1 | 1 | 0 | −98 | |
| 1.125 | 1 | 1 | 0 | −112.5 | |
| 0.8125 | 0 | 0 | 0 | −128 | |
| 1.5 | 1 | 1 | 0 | −144.5 | |
| 1.1875 | 1 | 1 | 0 | −162 | |
| 0.875 | 0 | 0 | 0 | −180.5 | |
| 1.5625 | 1 | 1 | 0 | −200 | |
| 1.25 | 1 | 1 | 0 | −220.5 | |
| 0.9375 | 0 | 0 | 0 | −242 | |
| 1.625 | 1 | 1 | 0 | −264.5 | |
| 1.3125 | 1 | 1 | 0 | −288 | |
| 1 | 1 | 0 | −1 | −312.5 | |
| 0.6875 | 0 | 1 | 0 | −338 | |
| 1.375 | 1 | 1 | 0 | −364.5 | |
| 1.0625 | 1 | 1 | 0 | −392 | |
| 0.75 | 0 | 0 | 0 | −420.5 | |
| 1.4375 | 1 | 1 | 0 | −450 | |
| 1.125 | 1 | 1 | 0 | −480.5 | |
| 0.8125 | 0 | 0 | 0 | −512 | |
| 1.5 | 1 | 1 | 0 | −644.5 | |
| 1.1875 | 1 | 1 | 0 | −578 | |
| 0.875 | 0 | 0 | 0 | −612.5 | |
| 1.5625 | 1 | 1 | 0 | −648 | |
| 1.25 | 1 | 1 | 0 | −684.5 | |
| 0.9375 | 0 | 0 | 0 | −722 | |
| 1.625 | 1 | 1 | 0 | −760.6 | |
| 1.3125 | 1 | 1 | 0 | −800 | |
| 1 | 1 | 0 | −1 | −840.5 | |
| 0.6875 | 0 | 1 | 0 | 882 | |

FIG. 16A-1

FIG. 16A-2

FIG. 16A

FIG. 16A-1

| | | | | | Correct Phase | $PC_n = k*(D_n - frac(RG_n) + 0.5 + \sum_i (W_i * X_{i+n-64}))$ PC |
|---|---|---|---|---|---|---|
| 1.375 | 1 | 1 | 0 | −924.5 | | |
| 1.0625 | 1 | 0 | −1 | −968 | | |
| 0.75 | 0 | 1 | 0 | −1012.5 | | |
| 1.4375 | 1 | 1 | 0 | −1068 | | |
| 1.125 | 1 | 1 | 0 | −1104.5 | | |
| 0.8125 | 0 | 0 | 0 | −1152 | | |
| 1.5 | 1 | 1 | 0 | −1200.5 | | |
| 1.1875 | 1 | 1 | 0 | −1250 | | |
| 0.875 | 0 | 0 | 0 | −1300.5 | | |
| 1.5625 | 1 | 1 | 0 | −1352 | | |
| 1.25 | 1 | 1 | 0 | −1404.5 | | |
| 0.9375 | 0 | 0 | 0 | −1458 | | |
| 1.625 | 1 | 1 | 0 | −1512.5 | | |
| 1.3125 | 1 | 1 | 0 | −1568 | | |
| 1 | 1 | 0 | −1 | −1624.5 | | |
| 0.6875 | 0 | 1 | 0 | −1682 | | |
| 1.375 | 1 | 1 | 0 | −1740.5 | | |
| 1.0625 | 1 | 0 | −1 | −1800 | | |
| 0.75 | 0 | 1 | 0 | −1860.5 | | |
| 1.4375 | 1 | 1 | 0 | −1922 | | |
| 1.125 | 1 | 1 | 0 | −1984.5 | | |
| 0.8125 | 0 | 0 | 0 | −2048 | | |
| 1.5 | 1 | 1 | 0 | 2048 | −53.374738 | −55.507692 |
| 1.1875 | 1 | 1 | 0 | 1984.5 | −54.054787 | −56.246154 |
| 0.875 | 0 | 0 | 0 | 1922 | −54.730895 | −56.984615 |
| 1.5625 | 1 | 1 | 0 | 1860.5 | −55.399059 | −57.723077 |
| 1.25 | 1 | 1 | 0 | 1800 | −56.059155 | −58.461538 |
| 0.9375 | 0 | 0 | 0 | 1740.5 | −56.711060 | −59.200000 |
| 1.625 | 1 | 1 | 0 | 1682 | −57.354650 | −59.938462 |
| 1.3125 | 1 | 1 | 0 | 1624.5 | −57.939800 | −60.676923 |

**FIG. 16A-2**

FIG. 16B

Ave Error= 1.501476

FIG. 16C

FIG. 17

ACCUMULATION    QUANTIZATION

**FIG.** 18

**FIG.** 20

| Accumulator $G_n = G_{n-1} + 0.6875 - INT(G_{n-1})$ | Data Stream $R_n = INT(G_n)$ |
|---|---|
| 0.6875 | 0 |
| 1.375 | 1 |
| 1.0625 | 1 |
| 0.75 | 0 |
| 1.4375 | 1 |
| 1.125 | 1 |
| 0.8125 | 0 |
| 1.5 | 1 |
| 1.1875 | 1 |
| 0.875 | 0 |
| 1.5625 | 1 |
| 1.25 | 1 |
| 0.9375 | 0 |
| 1.625 | 1 |
| 1.3125 | 1 |
| 1 | 1 |
| 0.6875 | 0 |

**FIG.** 19

EP 1 057 252 B1

EP 1 057 252 B1

Extra Stage(s) may
be needed to minimize
metastability

*2101*

CH1

These two sections
must be carefully
matched to
minimize errors

CH2

D Q    Q1
CI Q̄

D Q    Q3
CI

D Q    Q5
CI Q̄

N1

D Q    Q2
CI

D Q    Q4
CI

D Q    Q6
CI Q̄

N2

N3
Data Samples X

Fx
Fs

*2103*

**Fig.** *21*

35

**EP 1 057 252 B1**

## REFERENCES CITED IN THE DESCRIPTION

*This list of references cited by the applicant is for the reader's convenience only. It does not form part of the European patent document. Even though great care has been taken in compiling the references, errors or omissions cannot be excluded and the EPO disclaims all liability in this regard.*

**Patent documents cited in the description**

- US 4125817 A
- US 4746880 A
- US 006938 A

**Non-patent literature cited in the description**

- **CANDY et al.** Oversampling Delta-Sigma Data Converters. *IEEE Press,* 1992, 1-6